# EUROPEAN PATENT APPLICATION

(11) **EP 4 600 745 A1**
(43) Date of publication of application: **13.08.2025**
(21) Application number: 24156718.9
(22) Date of filing: 09.02.2024
(51) Int. Cl.: G03F 7/20

(54) **METHOD AND DEVICE FOR PATTERN GENERATION**

(71) Applicant: Mycronic AB, 183 03 Täby (SE)
(72) Inventor: Luthman, David, 187 76 Täby (SE); Khavari, Faraz, 183 71 Täby (SE); Björnberg, Charles, 183 58 Täby (SE); Beiming, Peter, 122 63 Enskede (SE); Glimtoft, Martin, 125 58 Älvsjö (SE)
(74) Representative: AWA Sweden AB

(57) **Abstract**

A method for preparing rasterized patterns for writing of patterns on a radiation-sensitive blank is provided. The radiation-sensitive blank has a bottom anti reflection coating - BARC - covered with a photoresist layer. The said writing method comprises obtaining (S10) of original data representing a pattern to be printed. The original data is rasterized (S30) into the rasterized pattern. Data is obtained (S20) defining a thickness measure of the BARC as a function of lateral position of a radiation-sensitive blank to be patterned. The rasterizing comprises adapting of pattern properties in dependence on the thickness measure of an intended pattern position at the radiation-sensitive blank to be patterned, creating a blank-specific rasterized pattern. A method for writing of patterns on a radiation-sensitive blank is also disclosed, as well as a rasterization module and a pattern generator, utilizing the method for preparing rasterized patterns.

## Description

### TECHNICAL FIELD

The present invention relates in general to pattern generators and in particular to methods and devices for writing of patterns on a radiation-sensitive blank.

### BACKGROUND

Pattern generators are today used for many types of purposes. Pattern generators used in lithography systems or photomask lithography systems are required to present very accurate printing properties. Scanning lithographic laser writers, e.g. mask writers, use laser to generate or write highly detailed patterns. Pattern Generators (PG) can today generate features down to the size of at least 0.35 pm. Typically laser writers use a laser as the light source to activate a photoresist of a radiation-sensitive blank. In a typical example, the exposure laser works in the visible or near visible spectrum, often in a range of 240 - 415 nm wavelength, i.e. violet or ultraviolet (UV). Power stability and low optical noise of the laser is crucial for writing performance.

The laser typically writes on a glass substrate, typically soda-lime or quartz, coated with layers of chrome, chromium oxide and photoresist. This is a typical example of a radiation-sensitive blank. The entire radiation-sensitive blank has typically a thickness in the range of 1 - 20 mm. The chromium oxide acts as an anti-reflection coating. The chrome and chromium oxide layers are thin and has together typically a thickness in the range of 700-1000 Å, but for higher resolution writing it may be even thinner. The laser writes the intended pattern into the resist layer. High power stability and low optical noise of the laser are crucial to ensure optimum writing performance. The resist layer thickness can vary considerably depending on the customer/application but may in a typical case be between 3300-4600Å.

A requested pattern to be printed is provided. Computers in the pattern generator perform pre-processing of the pattern, generating a layout of the pattern for the substrate, and converts the pattern data to a format readable by the mask writer. The pre-processing may also compensate the pattern data for known inconsistencies/imperfections in the pattern generator, e.g., in the optical components shaping the laser.

CD is the critical dimension (or size) of a given feature, and it can typically be described as a linewidth. CD Uniformity is the statistical spread of a given linewidth.

Any minor change in the substrate topography may affect the resulting pattern/mask when writing nanometer scale patterns. It has been noticed that when exposing and measuring a test pattern to measure the global CD uniformity of a pattern generator, the results almost always include a consistent variation of the CD across the plate. It has also been found that these variations may vary from plate to plate.

### SUMMARY

A general object of the present technology is therefore to improve the homogeneity of CD properties over the surface of a substrate.

The above object is achieved by methods and devices according to the independent claims. Preferred embodiments are defined in dependent claims.

In general words, in a first aspect, a method for preparing rasterized patterns for writing of patterns on a radiation-sensitive blank is provided. The radiation-sensitive blank has a bottom anti reflection coating - BARC - covered with a photoresist layer. The said writing method comprises obtaining of original data representing a pattern to be printed. The original data is rasterized into the rasterized pattern. Data is obtained defining a thickness measure of the BARC as a function of lateral position of a radiation-sensitive blank to be patterned. The rasterizing comprises adapting of pattern properties in dependence on the thickness measure of an intended pattern position at the radiation-sensitive blank to be patterned, creating a blank-specific rasterized pattern.

In a second aspect, a method for writing of patterns on a radiation-sensitive blank is provided. The radiation-sensitive blank having a bottom anti reflection coating - BARC - covered with a photoresist layer. The method comprises preparing of rasterized patterns for writing of patterns on a radiation-sensitive blank according to the first aspect. The method further comprises writing, by irradiating the radiation-sensitive blank to be patterned, according to the rasterized pattern.

In a third aspect, a rasterization module for pattern generators operating on a radiation-sensitive blank is provided. The radiation-sensitive blank has a bottom anti reflection coating - BARC - covered with a photoresist layer. The rasterization module comprises a processor and a memory. The memory comprising instructions executable by the processor, whereby the rasterization module is configured to obtain original data, representing a pattern to be printed, to rasterize the original data into a rasterized pattern, and to obtain data defining a thickness measure of the BARC as a function of lateral position of a radiation-sensitive blank to be patterned. The rasterizing comprises adapting pattern properties in dependence on the thickness measure of an intended pattern position at the radiation-sensitive blank to be patterned, thereby creating a blank-specific rasterized pattern.

In a fourth aspect, a pattern generator comprises a control unit, having a rasterization module according to the third aspect and an imaging module. The imaging module is arranged for writing a pattern by irradiating the radiation-sensitive blank to be patterned according to the rasterized pattern.

One advantage with the proposed technology is that CD variations across the radiation-sensitive blank. Other advantages will be appreciated when reading the detailed description.

### BRIEF DESCRIPTION OF THE DRAWINGS

The invention, together with further objects and advantages thereof, may best be understood by making reference to the following description taken together with the accompanying drawings, in which:
FIG. 1 illustrates schematically a typical example of a radiation-sensitive blank;
FIG. 2 is a flow diagram of steps of an embodiment of a method for preparing rasterized patterns;
FIG. 3 is a flow diagram of steps of an embodiment of a method for writing of patterns on a radiation-sensitive blank;
FIG. 4 is a flow diagram of steps of another embodiment of a method for writing of patterns on a radiation-sensitive blank;
FIG.5 is a schematic illustration of an embodiment of a rasterization module;
FIG. 6 is a schematic illustration of an embodiment of a pattern generator;
FIG. 7A is a diagram illustrating CD variations over a part of a radiation-sensitive blank; and
FIG. 7B is a diagram illustrating CD variations over a part of a radiation-sensitive blank with adaptations made in dependence on thickness measures of the BARC.

### DETAILED DESCRIPTION

Throughout the drawings, the same reference numbers are used for similar or corresponding elements.

In the present disclosure, the term "radiation-sensitive blank" is used to denote all types of flat surfaces used for printing purposes by irradiation, based on e.g. wafers or glass sheets. The radiation-sensitive blank presents at least a bottom anti-reflection coating (BARC) covered with a photoresist layer. The radiation-sensitive blank may e.g. be substrates for mask writing or substrates for direct writers.

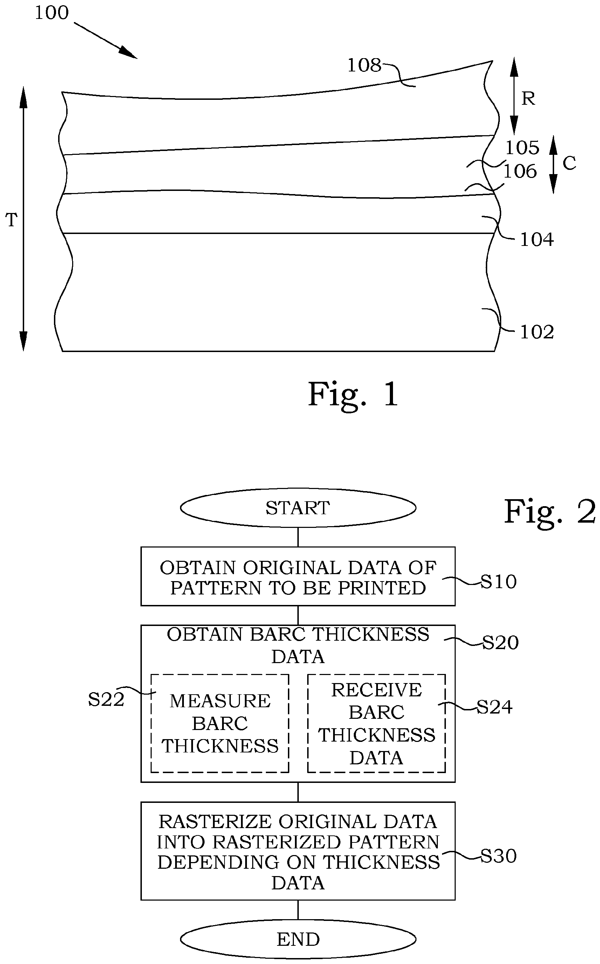

For a better understanding of the proposed technology, it may be useful to begin with a brief overview how a typical radiation-sensitive blank is composed. Figure 1 illustrates schematically a typical example of a radiation-sensitive blank 100. In this particular embodiment the radiation-sensitive blank 100 is based on a glass substrate 102. A thin layer of chromium 104 covers one surface of the glass substrate and a layer of chromium oxide 106 covers the chromium layer 104. On top of the chromium oxide 106, a photoresist layer 108 is provided. The chromium oxide 106 functions as a BARC 105, which means that light transmitted through the photoresist layer 108 is at least partially reflected back. The photoresist layer 108 may be any type of photoresist, well-known by any person skilled in the art of lithography.

Note that the figure is not drawn with proper scales, for illustration purposes. A thickness R of the photoresist layer 108 is typically in the order of 3300 - 4600 Å. The chromium layer 104 and the chromium oxide layer 106 have together a thickness C of typically around 700-1000 Å, but sometimes even thinner. A total thickness T of the radiation-sensitive blank 100 is in this embodiment 1 - 20 mm. However, the exact mentioned measures of the thicknesses are only given to give an understanding of the general magnitudes of thicknesses and should not be considered as limiting for the application of the present technology. The present technology may therefore be applied to systems having layer thicknesses deviating from the above-mentioned ranges as well.

The chromium and chromium oxide layers 104, 106, are typically provided onto the glass substrate 102 by different deposition techniques, such as e.g. sputtering techniques. Typically, the chromium and chromium oxide layers are not binary, i.e. the boundary between the layers is typically a gradual transition from one to the other. The photoresist layer 108 is typically spin-coated on top of the chromium oxide. The different coating techniques are associated with different challenges for providing coatings with homogeneous thicknesses over a large surface. It is e.g. well known the that spin-coating has a tendency to give a slightly thicker coating at the outer parts of the surfaces to be coated. Sputtering may also be difficult to control to give an even distribution over larger surfaces. Note that in the figure, the illustrated thickness variations are extremely exaggerated, for educational purposes.

Measurements of the spatial thickness variations of the different layers over the area of a radiation-sensitive blank were performed. After writing of a test pattern and developing the radiation-sensitive blank, there was as usual a minor variation of CD over the same area. This CD variation was determined and compared to the thickness variations. It was surprisingly found that there was no correlation between photoresist layer thickness and the detected CD variation, or at least that the correlation was weak. However, at the contrary, it was found that there existed a significant correlation between the detected CD variation and the thickness of the chromium oxide layer, i.e. the BARC. The chromium oxide layer thickness can for instance be measured using a spectroscopic reflectometer. In the original tests, a NanoSpec 6000 was applied. Chromium oxide thickness variations across the plate often take the appearance of a tilt or a slope. The same behaviour was found in CD variations, and they were directed in the same directions. However, the chromium oxide layers of different individual radiation-sensitive blanks differed, both between radiation-sensitive blanks of a same producer as well as from different producers.

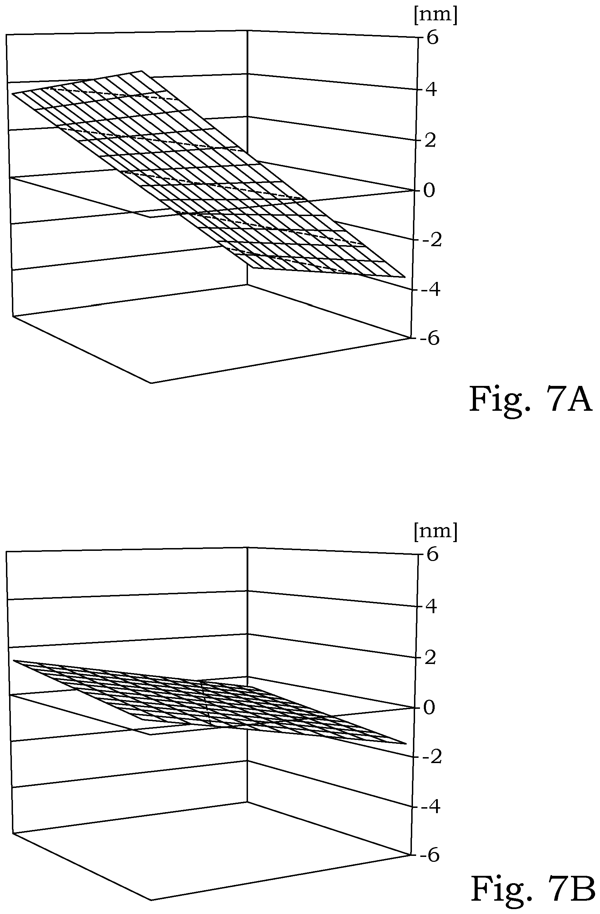

Figure 7A illustrates schematically variations of CD of printed patterns across a part of a radiation-sensitive blank. The radiation-sensitive blank presented a slightly varying BARC thickness having the same general geometrical direction as the CD variations.

CD properties can be tuned by adapting the print data that is used by a writer. However, since the required adaptations were different for different radiation-sensitive blanks, no general print data adaptation for all blanks can be employed. However, once the thickness variations over a particular radiation-sensitive blank is known, adaptations of print data can be performed, thereby reducing the CD variations.

Figure 7B illustrates schematically variations of CD of adapted printed patterns across a part of a corresponding radiation-sensitive blank. The adaptation is made in dependence on the thickness measure of the BARC of the radiation-sensitive blank. Compared to the non-adapted case, the total variation of CD over the area is reduced significantly.

Thus in one embodiment, as illustrated in Figure 2, a flow diagram of steps of an embodiment of a method for preparing rasterized patterns for writing of patterns on a radiation-sensitive blank is shown. The radiation-sensitive blank having a BARC covered with a photoresist layer. In a particular embodiment, the BARC is chromium oxide. In step S10, original data is obtained, representing a pattern to be printed. In step S20, data is obtained, defining a thickness measure of the BARC as a function of lateral position of a radiation-sensitive blank to be patterned.

In step S30, the original data is rasterized into a rasterized pattern. As a part step of the rasterizing step S30, as illustrated by step S32, pattern properties are adapted in dependence on the thickness measure of an intended pattern position at the radiation-sensitive blank to be patterned. This adaptation thereby creates a blank-specific rasterized pattern.

In one embodiment, as illustrated by step S22, the obtaining of data S20 defining the thickness measure comprises receiving data from an externally performed film thickness variation determination. In other words, when a radiation-sensitive blank is to be written on, data defining the BARC thickness distribution over that particular radiation-sensitive blank, measured at an earlier occasion, is delivered to the system to be used in the rasterizing step S30.

Alternatively, as illustrated by step S24, the obtaining of data S20 defining the thickness measure comprises measuring a film thickness variation of the BARC of the radiation-sensitive blank to be patterned. This measuring is preferably performed in connection with the writing. It is not necessarily performed within the writing space itself, but it is presently considered as being an advantage to integrate the measuring in the same clean-room space as the subsequent writing.

The purpose of the method is that, based on the BARC topography measurements, a plate-specific CD compensation map can be generated. After the measurement, the pattern paired to the plate would then be prepared with a CD compensation using the obtained map. This CD compensation map may be used in pre-processing of the pattern data to compensate the printing process based on the measured topography. After creating the map, the pattern would be prepared specifically for that measured plate. By adapting the pattern to each individual plate, the CD uniformity may be improved for each individual plate. The creation of the map and compensation associated therewith may of course be integrated as an integrated part of the rasterizing process.

A correlation was found between CD variations and BARC thickness variations. Even if the actual thickness measures differed from one radiation-sensitive blank to another, the relation between BARC thickness variation and CD variation further seemed to be relatively constant between different radiation-sensitive blanks. This thereby opens up for an adaption process. According to one embodiment, the adapting of the pattern properties performed at a pattern position, associated with a point at the radiation-sensitive blank to be patterned, is performed by an amount that is a function of a thickness measure corresponding to that same point at the radiation-sensitive blank to be patterned. In a first approximation, this relationship was found to be more or less linear. Therefore in one embodiment, the adapting of the pattern properties performed at the pattern position, associated with the point at the radiation-sensitive blank to be patterned, is performed by an amount being a linear function of the thickness measure corresponding to the point at the radiation-sensitive blank to be patterned.

The adapting of the pattern properties can be performed according to different approaches that are used for other CD compensation processes. These approaches are, as such, well-known by any person skilled in the art. In the particular case of adapting the pattern properties for compensating differing BARC thicknesses, two alternatives are presently considered as most promising. In one embodiment, the adapting of the pattern properties comprises edge displacements in the pattern. In another embodiment, the adapting of the pattern properties comprises varying irradiance in the pattern. These two alternatives can also be combined.

The most common example of a BARC in the field of transmitting photomasks is a chromium oxide, CrₓO, layer. Most verifying tests have also been performed using chromium oxide as a BARC. However, also SiOa, SiON or CrₓO_{y}N can be used as BARC. For reflective masks, a Mo/Si layer may also be used as a BARC. Even other choices, such as MgₓF_{y}, TiO₂, BNₓ or SiC are feasible.

Since the BARC typically has another etching rate than the layer beneath, a thickness variation will influence the total etching time. Furthermore, thickness variation in the BARC may in turn be correlated to thickness variations in the layer below BARC, which may lead to varying etching rates over the surface. Varying etching rates give rise to CD variations.

If the measuring of the thickness variation is performed in connection with the final writing operation, a practical, easy-to-perform, fast, cheap, accurate, non-destructive method has to be employed. Spectroscopic reflectometry, ellipsometry and interferometry has been found to be possible alternatives. Thus, in one particular embodiment, the measuring of the film thickness variation of the BARC of the radiation-sensitive blank to be patterned is performed by spectroscopic reflectometry, in another particular embodiment, the measuring of the film thickness variation of the BARC of the radiation-sensitive blank to be patterned is performed by ellipsometry and in yet another particular embodiment, the measuring of the film thickness variation of the BARC of the radiation-sensitive blank to be patterned is performed by interferometry.

However, other methods may also be used, as long as the radiation-sensitive blank is not destroyed, and the depth resolution is sufficient. Plausible other techniques can e.g. be X-ray reflectometry, X-ray fluorescence, atomic force microscopy, electrical resistivity/conductivity measurements, or Rutherford backscattering spectrometry.

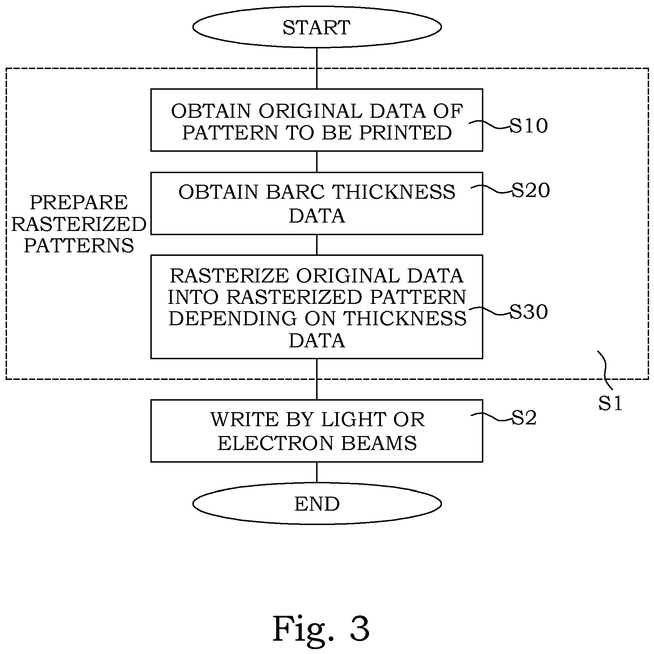

The preparing of rasterized patterns according to the description above is of course intended to be used for a writing operation. Figure 3 illustrates a flow diagram of steps of an embodiment of a method for writing of patterns on a radiation-sensitive blank. The radiation-sensitive blank has a BARC covered with a photoresist layer. In step S1, rasterized patterns are prepared for writing of patterns on a radiation-sensitive blank according to the technology presented here above. Step S2 comprises writing, by irradiating the radiation-sensitive blank to be patterned, according to the rasterized pattern.

In a preferred embodiment, the irradiating of the radiation-sensitive blank to be patterned is performed by light or electron beams.

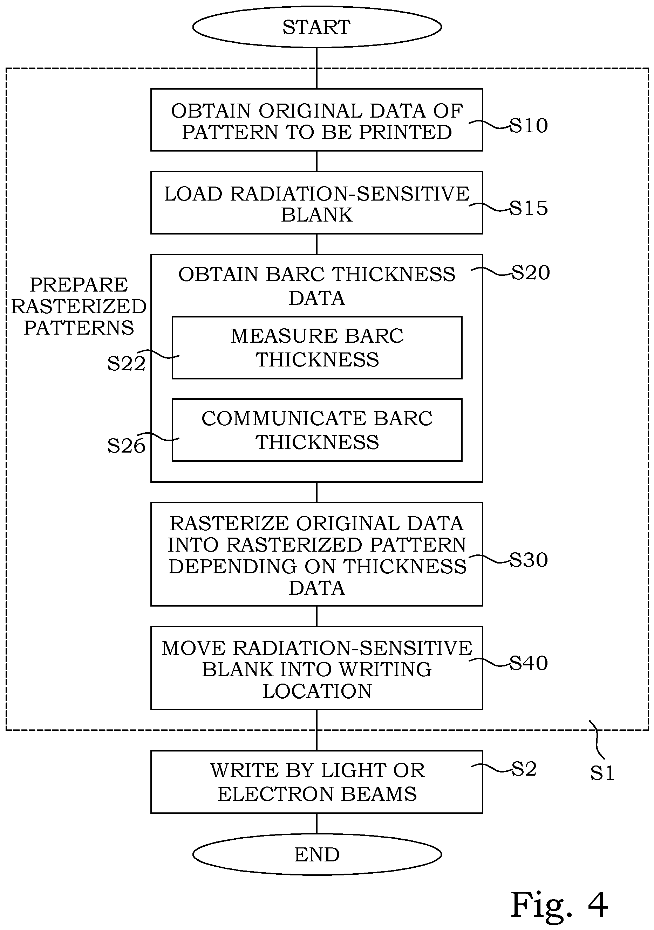

As indicated above, in step S22, the BARC thickness is measured. In one embodiment, as illustrated in Figure 4, this is performed in connection with the writing. In step S15, the radiation-sensitive blank to be patterned is loaded into a loading section. This step can be performed before, after or at least partly simultaneously as step S10. In step S22, as described above, the obtaining of data defining the thickness measure is performed according to what was described above while the radiation-sensitive blank to be patterned is present in the loading section. In step S26, data representing the determined film thickness variation is communicated to be used in the rasterizing. In step S40, the radiation-sensitive blank to be patterned is moved into a location where the writing is to be performed. Step S40 can be performed before, after or at least partially simultaneously as step S30. Preferably, at least a part of the time it takes for the radiation-sensitive blank to be moved may be utilized for the necessary calculations concerning the rasterization.

Integrating a BARC thickness metering, e.g. by a spectroscopic reflectometer, into the mask writer procedure may automate the measurement and CD compensation for a plate. In addition, this implementation removes the risk of human error, e.g., plate rotation, and cleanliness issues with handling plates during the measurement. By performing the measurements at the loading site, the throughput of the mask writers does not necessarily decrease.

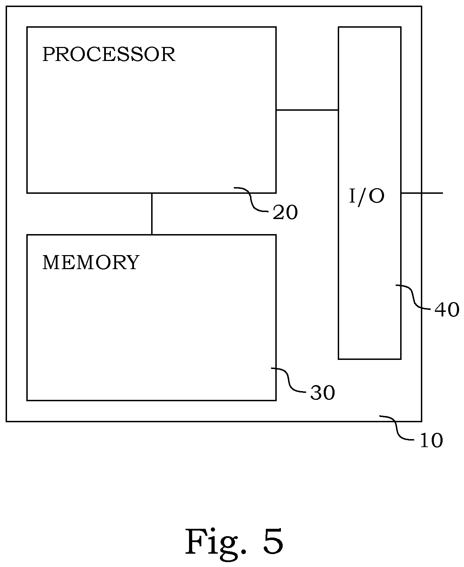

In an apparatus view, a rasterization module may be used for preparing data for a pattern generator. Figure 5 illustrates schematically a rasterization module 10 for pattern generators operating on a radiation-sensitive blank. The radiation-sensitive blank is intended to be a radiation-sensitive blank having a BARC covered with a photoresist layer. The rasterization module 10 comprises a processor 20 and a memory 30. The memory 30 comprises instructions executable by the processor 20, whereby the rasterization module 10 is configured to obtain original data, representing a pattern to be printed, to rasterize the original data into a rasterized pattern, and to obtain data defining a thickness measure of the BARC as a function of lateral position of a radiation-sensitive blank to be patterned. The rasterizing comprises adapting of pattern properties in dependence on the thickness measure of an intended pattern position at the radiation-sensitive blank to be patterned. This results in the creation of a substrate-specific rasterized pattern. The rasterization module 10 communicates with other modules via an I/O interface 40.

Preferably, the adapting of the pattern properties performed at a pattern position, associated with a point at the radiation-sensitive blank to be patterned, is performed by an amount that is a function of a thickness measure corresponding to the point at the radiation-sensitive blank to be patterned.

In one embodiment, the adapting of the pattern properties performed at the pattern position, associated with the point at the radiation-sensitive blank to be patterned, is performed by an amount that is a linear function of the thickness measure corresponding to the point at the radiation-sensitive blank to be patterned.

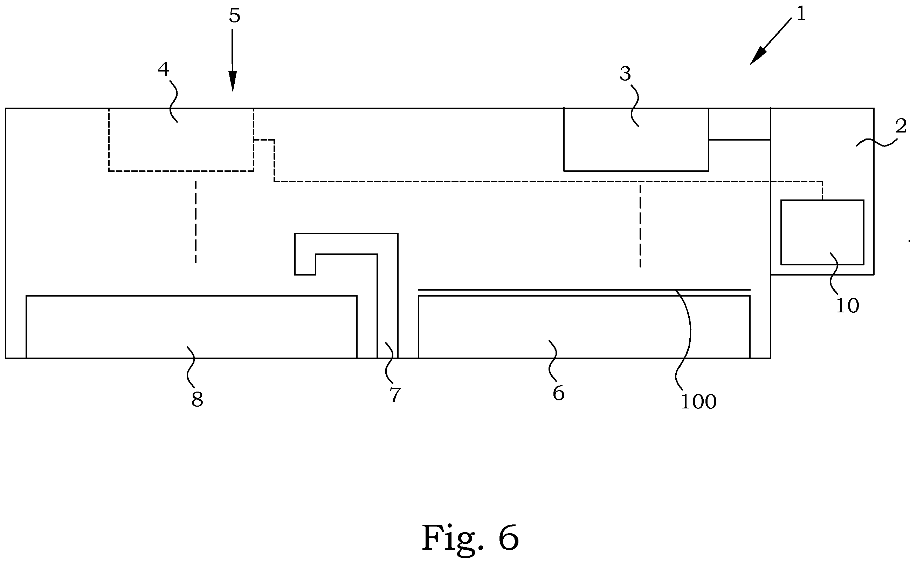

Figure 6 schematically illustrates a pattern generator 1. The pattern generator 1 comprises a control unit 2. The control unit 2 has a rasterization module 10 according to Figure 5. An imaging module 3 is arranged for writing a pattern by irradiating the radiation-sensitive blank 100 to be patterned according to the rasterized pattern.

According to a preferred embodiment, a BARC thickness measurement equipment, e.g. a spectroscopic reflectometer, is integrated into the pattern generator 1 to determine the thickness of the BARC, e.g. a chromium oxide layer. To improve efficiency and not prolong the writing process, thickness measurements could be performed while the plate is e.g. in a location 8 that a loading robot 7 can reach, typically in a loading section 5. The loading robot 7 is a specific unit, as such known to any person skilled in the art, used to load the radiation-sensitive blank 100 into the writing position 6 of the pattern generator 1.

The imaging module 4, e.g. the spectroscopic reflectometer, may be arranged above the location 8 reached by the loading robot 7. The loading robot may place the radiation-sensitive blank 100 to measure the thickness of different layers on the radiation-sensitive blank 100 in a sufficient number of places to generate the map. Integrating e.g. a spectroscopic reflectometer into the pattern generator 1 may automate the measurement and CD compensation for a radiation-sensitive blank 100. In addition, as mentioned above, this implementation removes the risk of human error, e.g. plate rotation, and cleanliness issues with handling plates during the measurement. By performing the measurements at the loading robot, the throughput of pattern generators does not necessarily decrease.

In other words, in one embodiment, the pattern generator 1 comprises a thickness meter, arranged to measure a film thickness variation of the BARC of the radiation-sensitive blank to be patterned. The thickness meter is further arranged to communicate data representing the measured film thickness variation to the rasterization module.

Preferably, the thickness meter is a spectroscopic reflectometer.

In one embodiment, the pattern generator further comprises a loading section, into which the radiation-sensitive blank to be patterned is loaded. The loading section has transferring means, e.g. a loading robot, arranged to move the radiation-sensitive blank to be patterned into a location where the writing is to be performed. The thickness meter is arranged to perform the film thickness variation measurement of the radiation-sensitive blank to be patterned when the radiation-sensitive blank is located in the loading section.

Preferably, the imaging module comprises a light source or a source of an electron beam, whereby the irradiating of the substrate to be patterned is performed by light or electron beams.

The pattern generator is typically a mask writer or a direct writer.

The reduction of the dependency of the BARC homogeneity that is achieved by the present techniques also opens up for reducing plate thickness requirements. By being able to use radiation-sensitive blank of a lower quality without lower final accuracy of CD uniformity, this will potentially lower the radiation-sensitive blank costs without affecting CD uniformity.

The embodiments described above are to be understood as a few illustrative examples of the present invention. It will be understood by those skilled in the art that various modifications, combinations and changes may be made to the embodiments without departing from the scope of the present invention. In particular, different part solutions in the different embodiments can be combined in other configurations, where technically possible. The scope of the present invention is, however, defined by the appended claims.

## Claims

1. A method for preparing rasterized patterns for writing of patterns on a radiation-sensitive blank (100), wherein said radiation-sensitive blank (100) having bottom anti reflection coating - BARC (105) - covered with a photoresist layer (108), wherein said writing method comprises the steps of:
- obtaining (S10) original data representing a pattern to be printed;
- rasterizing (S30) said original data into said rasterized pattern;
- obtaining (S20) data defining a thickness measure (C) of said BARC (105) as a function of lateral position of a radiation-sensitive blank (100) to be patterned;
wherein said step of rasterizing (S30) comprises adapting pattern properties in dependence on said thickness measure (C) of an intended pattern position at said radiation-sensitive blank (100) to be patterned, creating a blank-specific rasterized pattern.

2. The method according to claim 1, **characterized in that** said adapting of said pattern properties performed at a pattern position, associated with a point at said radiation-sensitive blank (100) to be patterned, is performed by an amount being a function of a thickness measure (C) corresponding to said point at said radiation-sensitive blank (100) to be patterned.

3. The method according to claim 2, **characterized in that** said adapting of said pattern properties performed at said pattern position, associated with said point at said radiation-sensitive blank (100) to be patterned, is performed by an amount being a linear function of said thickness measure (C) corresponding to said point at said radiation-sensitive blank (100) to be patterned.

4. The method according to claim 2 or 3, **characterized in that** said adapting of said pattern properties comprises edge displacements in said pattern.

5. The method according to claim 2 or 3, **characterized in that** said adapting of said pattern properties comprises varying irradiance in said pattern.

6. The method according to any of the claims 1 to 5, **characterized in that** said obtaining of data defining said thickness measure (C) comprises measuring a film thickness variation of said BARC (105) of said radiation-sensitive blank (100) to be patterned.

7. The method according to any of the claims 1 to 3, **characterized in that** said obtaining of data defining said thickness measure (C) comprises receiving data from an externally performed film thickness variation determination.

8. A method for writing of patterns on a radiation-sensitive blank (100), wherein said radiation-sensitive blank (100) having a bottom anti reflection coating - BARC (105) - covered with a photoresist layer (108), wherein said method comprises:
- preparing (S1) rasterized patterns for writing of patterns on a radiation-sensitive blank (100) according to any of the claims 1 to 7; and
- writing (S2), by irradiating said radiation-sensitive blank (100) to be patterned, according to said rasterized pattern.

9. The method for writing of patterns according to claim 8, **characterized by** comprising the further steps of:
- loading (S15) said radiation-sensitive blank to be patterned into a loading section (5);
- performing said obtaining (S20) of data defining said thickness measure (C) according to claim 4 while said radiation-sensitive blank (100) to be patterned is present in said loading section (5);
- communicating (26) data representing said determined film thickness variation to be used in said rasterizing; and
- moving (S40) said radiation-sensitive blank (100) to be patterned into a location (6) where said writing is to be performed.

10. A rasterization module (10) for pattern generators operating on a radiation-sensitive blank (100), wherein said radiation-sensitive blank (100) having a bottom anti reflection coating - BARC (106) - covered with a photoresist layer (108), said rasterization module (10) comprising:
- a processor (20); and
- a memory (30);
said memory (30) comprising instructions executable by the processor (20), whereby said rasterization module (10) is configured to:
- obtain (S10) original data, representing a pattern to be printed;
- rasterizing (S30) said original data into a rasterized pattern;
- obtain (S20) data defining a thickness measure of said BARC (106) as a function of lateral position of a radiation-sensitive blank (100) to be patterned;
wherein said rasterizing (S30) comprises adapting pattern properties in dependence on said thickness measure (C) of an intended pattern position at said radiation-sensitive blank (100) to be patterned, creating a blank-specific rasterized pattern.

11. The rasterization module according to claim 10, **characterized in that** said adapting of said pattern properties performed at a pattern position, associated with a point at said radiation-sensitive blank (100) to be patterned, is performed by an amount being a function of a thickness measure (C) corresponding to said point at said radiation-sensitive blank (100) to be patterned.

12. The rasterization module according to claim 11, **characterized in that** said adapting of said pattern properties performed at said pattern position, associated with said point at said radiation-sensitive blank (100) to be patterned, is performed by an amount being a linear function of said thickness measure (C) corresponding to said point at said radiation-sensitive blank (100) to be patterned.

13. A pattern generator (1), comprising:
- a control unit (2), having a rasterization module (10) according to any of the claim 10 to 12; and
- an imaging module (3) arranged for writing a pattern by irradiating said radiation-sensitive blank (100) to be patterned according to said rasterized pattern.

14. The pattern generator according to claim 13, **characterized by** further comprising:
- a thickness meter (4), arranged to measure a film thickness variation of said BARC (106) of said radiation-sensitive blank (100) to be patterned;
wherein said thickness meter (4) being further arranged to communicate data representing said measured film thickness variation to said rasterization module (10).

15. The pattern generator according to claim 14, **characterized by** further comprising:
- a loading section (5), into which said radiation-sensitive blank (100) to be patterned is loaded;
wherein said loading section (5) having transferring means (7) arranged to move said radiation-sensitive blank (100) to be patterned into a location (8) where said writing is to be performed;
wherein said thickness meter (4) being arranged to perform said film thickness variation measurement of said radiation-sensitive blank (100) to be patterned when being located in said loading section (5).
